# EUROPÄISCHE PATENTSCHRIFT

(11) **EP 0 966 732 B1**
(45) Veröffentlichungstag und Bekanntmachung des Hinweises auf die Patenterteilung: **04.10.2001**
(21) Anmeldenummer: 98916852.1
(22) Anmeldetag: 28.02.1998
(51) Int. Cl.: G08B 17/00, A62C 39/00

(54) **SCHALTSCHRANK MIT FEUERLÖSCHSYSTEM**
SWITCH CABINET WITH A FIRE EXTINGUISHING SYSTEM
ARMOIRE ELECTRIQUE POURVUE D'UN SYSTEME D'EXTINCTION D'INCENDIE

(30) Priorität: 11.03.1997 DE 19709683; 26.02.1998 DE 19807804
(43) Veröffentlichungstag der Anmeldung: 29.12.1999
(73) Patentinhaber: Seeliger, Hans-Dieter, 45468 Mülheim (DE); Kühn, Uwe, 45481 Mülheim (DE)
(72) Erfinder: Seeliger, Hans-Dieter, 45468 Mülheim (DE); Kühn, Uwe, 45481 Mülheim (DE)
(74) Vertreter: Schulte, Jörg, Dipl.-Ing.
(86) Internationale Anmeldenummer: DE9800639
(87) Internationale Veröffentlichungsnummer: WO9840858

(56) Entgegenhaltungen:
- EP-A- 0 459 944
- WO-A-95/02433
- DE-A- 3 433 459
- DE-A- 4 323 730
- DE-A- 4 343 887
- FR-A- 2 360 321
- FR-A- 2 523 455
- STRIEWISCH K F: "ARGON - EIN ERSATZ FUER HALON" PROTECTOR, Bd. 19, Nr. 5, 1.November 1991, Seiten 9-10, 12 - 13, XP000244610
- PATENT ABSTRACTS OF JAPAN vol. 097, no. 009, 30.September 1997 & JP 09 135919 A (NOHMI BOSAI LTD), 27.Mai 1997,

## Beschreibung

Die Erfindung betrifft einen Schaltschrank für Server u. ä. Einbauten insbesondere Teile empfindlicher Computereinrichtungen, dessen Innenraum mit Löschgas enthaltenden Gasflaschen verbunden ist und kontinuierlich über einen Ventilator mit Frischluft versorgt ist, wobei in den Abgasstrom ausserhalb des Innenraums Brandfrüherkennungssensoren geschaltet sind und wobei die Verbindung im Brandfall aktiviert ist.

Schaltschränke dienen zur Aufnahme von Anlagen und Einrichtungen, mit denen ganze Maschinenanlagen oder Gruppen von Maschinen gesteuert und geschaltet werden. In entsprechenden Schaltschränken können und werden auch Server und hochempfindliche sonstige Computereinrichtungen untergebracht, die zunächst einmal dem Zugriff Unberechtigter entzogen werden sollen und die zugleich auch gegen sonstige Einflüsse, manchmal auch klimatischer Art geschützt werden sollen. Bekannt ist es darüber hinaus, entsprechende Einrichtungen und Anlagen in Schaltschränken unterzubringen, die sich selbst entzünden und damit gefährden können, die aber auch die Umwelt gefährden. Dabei wird versucht, mit Inertgasen der evtl. aufgetretenen Flamme den Sauerstoff zu entziehen. Entsprechende Schaltschränke u. ä. Anlagen haben sich bisher aber wegen des damit verbundenen großen Aufwandes nicht durchsetzen können.

Aus der DE-OS 34 33 459 ist eine Einrichtung zur Früherkennung eines Brandes und Überhitzung an Gehäusen und Schränken bekannt, die elektrische oder elektronische Anlagen umschließt. Dabei wird eine Rauchdetektion unmittelbar am Abluftaustritt der zu überwachenden Einheit beispielsweise mit Hilfe eines Ansaugtrichters vorgenommen. Hier wird also eine Einrichtung zur Überwachung einer elektronischen Anlage hinsichtlich Brandschutz vorgestellt. Die FR 523 455 lehrt eine Schaltung für eine kombinierte Rauchmeldungs- und Löscheinheit, bei welcher allerdings nachteilhafterweise ein Löschmittel freigesetzt wird, dass die in einem Schrank untergebrachten Geräte für die weitere Benutzung unbrauchbar macht. Die EP 459 944 schlägt den Einsatz von Kohlendioxyd als Löschmittel vor, um gezielt nur auf die von einem Brand betroffene Anlage einwirken und somit die Brand- und Löschfolgeschäden auf ein Minimum beschränken zu können. Dazu sind ein Branddetektor im Warmluftstrom der zu schützenden Anlage und eine Austrittsöffnung des Löschmittelbehälters innerhalb des Gehäuses der Anlage vorgesehen. Dabei hat sich die fehlende Zuverlässigkeit dieser Steuerung als nachteilig erwiesen, da zum einen keine aktive Probeaufnahme vorgesehen ist und zum anderen im Brandfall keine zufriedenstellend schnelle und sichere Löschung erreicht wird. Entstehender Rauch erreicht mehr oder weniger zufällig die Branddetektoren, wodurch dann die Freisetzung von Kohlendioxyd bewirkt wird. Das Kohlendioxid drückt den Sauerstoff durch Öffnungen aus dem Gerät heraus, bis die Flamme erstickt ist. Nachbrände können nicht verhindert werden.

Der Erfindung liegt daher die Aufgabe zugrunde, einen Server u.ä. hochempfindliche Computerteile schützenden Schaltschrank zu schaffen, bei dem im Falle eines Innenraumbrandes dieser datenneutral bzw. datensicher selbsttätig und zuverlässig umgehend gelöscht wird und der zugleich einen Nachbrand verhindernd ausgebildet ist.

Die Aufgabe wird gemäß der Erfindung dadurch gelöst, dass der Innenraum in einem gegen die Atmosphäre abgeschlossenen Schutzschrank ausgebildet und dass die im Brandfall über die Brandfrüherkennungssensoren aktivierten Gasflaschen mit dem Edelgas Argon gefüllt sind und dass der Innenraum über ein Versorgungsrohr mit der Atmosphäre verbunden ist, das am ausserhalb des Schutzschrankes befindlichen Ende eine kombinierte Ansaug- und Luftaustrittsdüse mit Gitterabdeckung aufweist und dass die Branderkennungssensoren und die gesamte Steuerung einem dem Schutzschrank zugeordneten Zusatzschrank zugeordnet sind.

Damit ist die Möglichkeit gegeben, den geschützten Schaltschrank kontinuierlich zu überwachen und im Brandfall vollautomatisch mit einem Löschgas und zwar einem vorteilhaft unschädlichen und die Umwelt nicht belastenden Inertgas zu fluten. Durch die Brandfrüherkennungssensoren bzw. die zugehörige Steuerung bleibt die brandhemmende Atmosphäre für einen vorbestimmten Zeitraum, beispielsweise 20 Minuten erhalten, sodass bis dahin der Feuerherd auf jeden Fall gelöscht ist und dann anschließend zwecks Reparatur begangen bzw. besichtigt werden kann. Das eingesetzte Löschgas Argon ist als normaler Bestandteil der Atmosphäre völlig unbedenklich, hat aber vor allem den großen Vorteil. dass im Gegensatz zu anderen Gasen wie beispielsweise Kohlendioxyd keinerlei Kälteschock entsteht. Die im Löschbereich angeordneten hochempfindlichen elektronischen Komponenten werden somit durch den Löschvorgang weder durch Feuchtigkeit noch durch Temperaturänderung in Mitleidenschaft gezogen. Damit ist ein vorteilhafter Doppeleffekt erreicht, ganz davon abgesehen, dass die kontinuierliche Zufuhr von Frischluft beim Normalbetrieb den Vorteil hat, dass im Schaltschrank auch eine bestimmte Temperatur eingehalten werden kann, so dass auch während dieses Betriebes negative Beeinflussungen der hochempfindlichen elektronischen Komponenten nicht eintreten können. Vorteilhaft ist außerdem, dass die vom Brand nicht betroffenen Bereiche der Einbauten weiterhin funktionsfähig bleiben. Durch eine entsprechende Steuerung können genau die Teile in einen Schaltzustand gebracht werden, der nach Abschluss oder nach Löschen des Brandes eine sofortige Wiederinbetriebnahme möglich macht. Vorteilhaft ist schließlich, dass die Räume, in denen die Schaltschränke angeordnet sind, für das Personal begehbar bleiben.

Eine besonders kompakte Ausbildung eines entsprechend gesicherten Schaltschrankes ist möglich, wenn die Brandfrüherkennungssensoren und die gesamte Steuerung einem dem Schutzschrank zugeordnet sind. Dieser Zusatzschrank kann dann so angeordnet werden, dass sowohl die Luftzuführung wie die Luftabführung für das Personal besonders angenehm ist, vor allem aber ist eine sehr kompakte Ausbildung möglich, insbesondere auch dann, wenn der Zusatzschrank dem Oberteil des Schutzschrankes angepasst ist, auch den Ventilator aufnimmt und mit dem Oberteil verbunden ist. Diese Ausbildung hat darüber hinaus den Vorteil, dass eine Nachrüstung problemlos möglich ist, weil lediglich einige wenige Bohrungen in der Deckwand angebracht werden müssen, um dann die Leitungen und die Rohre hindurchzuführen, die elektrisch und auch für die Luftzufuhr erforderlich sind.

Für die Erkennung eines Brandes ist lediglich eine geringe Luftzufuhr bzw. ein entsprechendes Absaugen notwendig, sodass der Ventilator nicht viel Platz bedarf und auch nur einen geringen Energiebedarf aufweist. Zweckmäßig ist es. wenn der Ventilator im Normalbetrieb auf Saugung geschaltet ist und im Brandfall von der Steuerung gestoppt ist. Dann wird zweckmäßigerweise die Verbindung, d. h. die Leitung in der Deckwand verschlossen, sodass weder noch weitere Luft durch den Ventilator herausgesaugt werden kann noch Luft durch die Öffnung eindringen kann. Durch die entsprechende Schaltung des Ventilators können die Brandfrüherkennungssensoren relativ dicht vor dem Ventilator und damit außerhalb des eigentlichen Schaltschrankes untergebracht werden, um so die durch den Ventilator herausgesaugte Luft entsprechend zu überprüfen und bei Erkennung eines Brandes sofort die entsprechenden Aggregate zu schalten.

Eine gezielte Zuführung der durch den Ventilator herausgesaugten Luft erfolgt, indem der Innenraum über ein Versorgungsrohr mit der Atmosphäre verbunden ist, das am außerhalb des Schutzschrankes befindlichen Ende eine kombinierte Ansaug- und Luftaustrittsdüse mit Gitterabdeckung aufweist. Während des Normalbetriebes saugt der Ventilator durch die Ansaugdüse die Luft an, die dann durch das Versorgungsrohr bis in den unteren Bereich des Schaltschrankes geführt wird und von dort aus nach oben streicht. Dabei kommt sie praktisch mit allen Teilen des Innenausbaus, beispielsweise des Servers in Verbindung, sodass sie evtl. auftretende Brände bereits während der Entstehung erkennungsmäßig nach außerhalb des Schaltschrankes trägt, wo über die Brandfrüherkennungssensoren die entsprechende Weiterverarbeitung erfolgt. Gleichzeitig ist dieser Ansaugdüse auch als Luftaustrittsdüse für den Brandfall einsetzbar, weil dann über eine entsprechende Düse das Edelgas Argon in den Innenraum hineingedrückt wird und dann über das Versorgungsrohr bzw. ein Ansaugrohr und die Luftaustrittsdüse nach außen weitergegeben wird. Dadurch, dass immer neues Argongas über das Versorgungsrohr nachströmt ist eine zügige Flutung des Innenraums des Schaltschrankes gesichert, wobei die brandhemmende Atmosphäre durch den Nachschub an Argon immer gewährleistet ist. Schädliche Brandgase werden zusammen mit dem Argon durch das Ansaugrohr wieder abgeführt und können auch im Schrank damit keine Nachteile hervorrufen. Um insbesondere beim Einsaugen der Luft auch über die Länge des Ansaugrohres einen zusätzlichen Austritt zu ermöglichen, ist vorgesehen, dass das Ansaugrohr neben der schrankseitigen Öffnung, also im Bereich des Bodens des Schrankes, über seine Länge gesehen mehrere Bohrungen aufweist. Frische Luft wird durch das Versorgungsrohr zur unteren Seite des Schrankes geführt und wird dann von den Sauglüftern in der Löschanlage an der Oberseite des Schrankes wieder abgesaugt. Daraus ergibt sich eine vollständige Belüftung des Innenraumes und damit auch eine sichere Zuführung von Brand- oder Rauchpartikeln zu den, hinter den Sauglüftern angeordneten Sensorsystemen.

Weiter vorn ist bereits auf die kompakte Bauweise des Schaltschrankes mit dem Zusatzschrank hingewiesen worden, wodurch es möglich wird, die Verbindung zwischen Glasflaschen und Schutzschrank als Rohrleitung auszubilden, wobei diese in der Deckwand des Schutzschrankes in Form einer Hochdruckgasdüse endet. Diese Hochdruckgasdüse sorgt zunächst einmal dafür, dass das einströmende Edelgas Argon gleichmäßig verteilt wird und darüber hinaus die Temperatur im Schaltschrank in etwa erhält, um die schon weiter oben erwähnten Nachteile durch einen Kälteschock zu vermeiden.

Die gezielte Verteilung und Behandlung des Argon wird insbesondere dadurch sichergestellt, dass die Hochdruckgasdüse einen Aufwärmauslass und einen Entspannungs- und Verteilraum aufweisend ausgebildet ist. Das Argon wird zunächst einmal im Bereich des Aufwärmauslasses komprimiert und damit aufgeheizt, sodass es mit entsprechender Temperatur in den Innenraum des Schaltschrankes einströmt. Es wird dann anschließend im Verteilraum so gleichmäßig verteilt, dass es alle Bereiche des Schaltschrankes schnell erreicht und für ein Löschen eines evtl. aufgetretenen Feuers sorgt.

Eine weitere zweckmäßige Weiterbildung ist die, bei der der Zusatzschrank auf der Oberseite Halterungen für Gasflaschen aufweist. Auch für den Weg von der Gasflasche zur Hochdruckgasdüse ist damit ein kurzer Weg vorgegeben, was nicht nur eine schnelle Verfügbarkeit sichert, sondern auch dafür sorgt, dass aufgrund der kurzen Rohrleitungen bzw, Verbindungsleitungen das zum Löschen benötigte Argon sehr frühzeitig zur Verfügung steht. Außerdem ergibt sich so eine sehr kompakte Ausbildung des gesamten Schaltschrankes mit dem oben aufgesetzten Zusatzschrank.

Insbesondere bei Servern u. ä. Geräten ist die Datensicherung ein großes Problem. Durch eine spezielle Auswerteelektronik gekoppelt mit der aktiven Mehrfachsensorik zur Brandfrüherkennung ist es aber möglich, schon im Entstehen eines Brandes oder einer sonstigen Gefahrensituation alle Daten so abzusichern, dass sie anschließend nicht mehr gefährdet sind. Dies erreicht man insbesondere dadurch, dass mindestens zwei Brandfrüherkennungssensoren vorgesehen sind, die unterschiedliche Schaltzeiten haben, wobei der mit der kürzeren Schaltzeit der Steuerung und dem Server bzw. Datensicherungsgerät und der mit der längeren Schaltzeit der Steuerung und dem Löschteil zugeschaltet ist. Damit wird sichergestellt, dass zunächst einmal bei Erkennen eines drohenden oder bereits anlaufenden Brandes alle wichtigen Daten gesichert werden, sodass auch bei einer Gefährdung des Servers oder der sonstigen Teile anschließend die vorhandenen Daten wieder zur Verfügung stehen. Erst wenn dies geschehen ist, wird das Löschteil aktiviert und der Löschprozess läuft entsprechend ab. Natürlich kann auch der Löschprozess bereits parallel eingeleitet werden, um die Zeit möglichst gering zu halten. Insgesamt handelt es sich so oder so nur um wenige Sekunden oder Minuten.

Es ist bereits darauf hingewiesen worden, dass die Räume, in denen entsprechende Schaltschränke untergebracht sind, auch bei auftretenden Bränden im Schaltschrank durch das Personal weiter begehbar sind. Damit ist auch sichergestellt, dass bei auftretendem Brand schnell Hilfe zur Verfügung steht, wobei dies noch dadurch optimiert wird, dass die Steuerung zugleich als Brandmeldeanlage ausgerüstet und mit dem Löschteil und einer Brandmeldezentrale verbunden ist. Über die Steuerung wird also nicht nur der Löschvorgang eingeleitet, sondern gleichzeitig wird auch der Brand einer Zentrale gemeldet, sodass weitere Sicherungs- und Hilfsaktivitäten eingeleitet werden können.

Um gegen alle Eventualitäten gesichert zu sein, ist vorgesehen, dass der Steuerung bzw. dem Zusatzschrank ein von Hand zu bedienender Power fail zugeordnet ist.

Die Erfindung zeichnet sich insbesondere dadurch aus, dass ein Schaltschrank geschaffen ist, der einen Server u. ä. hochempfindliche Computer schützen kann, der aber gleichzeitig auch andere wichtige Schaltelemente aufnehmen kann, um sie einmal vor dem Zugriff Unberechtigter zu schützen. gleichzeitg vor evtl. Klimastürzen oder sonstigen Beinflussungen zu sichern und auch vor allem sie selbst gegen auftretende Brände von Teilen der gesamten Anlagen bzw. der Schalter. Dies wird zunächst einmal durch eine geschlossene Atmosphäre erreicht, in der die entsprechenden Schalter und schalterähnlichen Teile untergebracht sind und die damit auch sicherstellt, dass im Brandfall eine Abschaltung durch eine Flutung mit Argon als Inertgas möglich ist. Über das Argon wird der Brand dann in kurzer Zeit gelöscht, sodass dann der Schrank bzw. die darin enthaltenen Teile wieder erreichbar sind. Eine Früherkennung des auftretenden Brandes wird dadurch möglich, dass kontinuierlich Frischluft in die den abgeschotteten Bereich, d. h. im Innenraum eingeleitet bzw. wiederabgesaugt wird, wobei im Absaugstrom Brandfrüherkennungssensoren dafür sorgen, dass bei auftretenden Bränden sehr frühzeitig bereits die entsprechenden Aktivitäten eingeleitet werden können. Dabei wird nicht nur die Flutung mit Argon eingeleitet, sondern gleichzeitig auch bzw. vorab eine Sicherung der Daten vorgenommen, sodass bei einem auftretenden Brand dieser nicht nur frühzeitig bekämpft sondern auch Schäden schon vorab weitgehend minimiert werden. Vorteilhaft ist weiter, dass die Inertgaslöschung ohne Schäden abläuft, weil das Löschmittel, d. h. das Argon nicht nur für die Umwelt unschädlich ist, sondern auch für die damit gelöschten Teile. Die Brandfrüherkennungssensoren ermöglichen eine Erkennung innerhalb weniger Sekunden und eine entsprechende Einleitung von Löschmaßnahmen. Die Räume, in den die Schutzschränke untergebracht sind, bleiben für das Personal begehbar, wobei das notwendige Feuerlöschsystem mit dem Schaltschrank zusammen eine kompakte Bauweise aufweist und die Vorschrift erfüllt ist, dass die für die Einleitung der Löschmaßnahmen notwendigen Teile außerhalb des Schaltschrankes selbst verbleiben. Durch entsprechende Energieversorgung ist die Möglichkeit gegeben, auch bei Stromausfall die Anlage bis zu 72 Stunden autark auszubilden. Vorteilhaft ist schließlich die Klartextbedienerführung und die Meldungsausgabe, wobei darüber hinaus durch Abfrage eine Ferndiagnose über die vorhandenen Datennetze möglich wird. Dadurch dass der Server oder die anderen Schalter frühzeitig geschaltet werden und zwar in eine Schaltstellung, die einen Wiederbetrieb kurz nach Ablauf der Brandarbeiten möglich macht, können Schäden insgesamt gering gehalten werden.

Weitere Einzelheiten und Vorteile des Erfindungsgegenstandes ergeben sich aus der nachfolgenden Beschreibung der zugehörigen Zeichnung, in der ein bevorzugtes Ausführungsbeispiel mit den dazu notwendigen Einzelheiten und Einzelteilen dargestellt ist. Es zeigen:
- Fig. 1: einen Schaltschrank in perspektivischer Wiedergabe, teilweise mit Darstellung von Teilen die im an sich nicht sichtbaren Innenraum angeordnet sind,
- Fig. 2: einen Schaltschrank bei Normalbetrieb und
- Fig. 3: einen Schaltschrank mit Argonzuführung im Brandfall,
- Fig. 4: ein Funktionschema eines entsprechenden Schaltschrankes,
- Fig. 5: eine Hochdruckgasdüse im Schnitt,
- Fig. 6: eine Seitenansicht der entsprechenden Düse,
- Fig. 7: eine Draufsicht auf den Zusatzschrank und
- Fig. 8: einen Schnitt durch den Zusatzschrank.

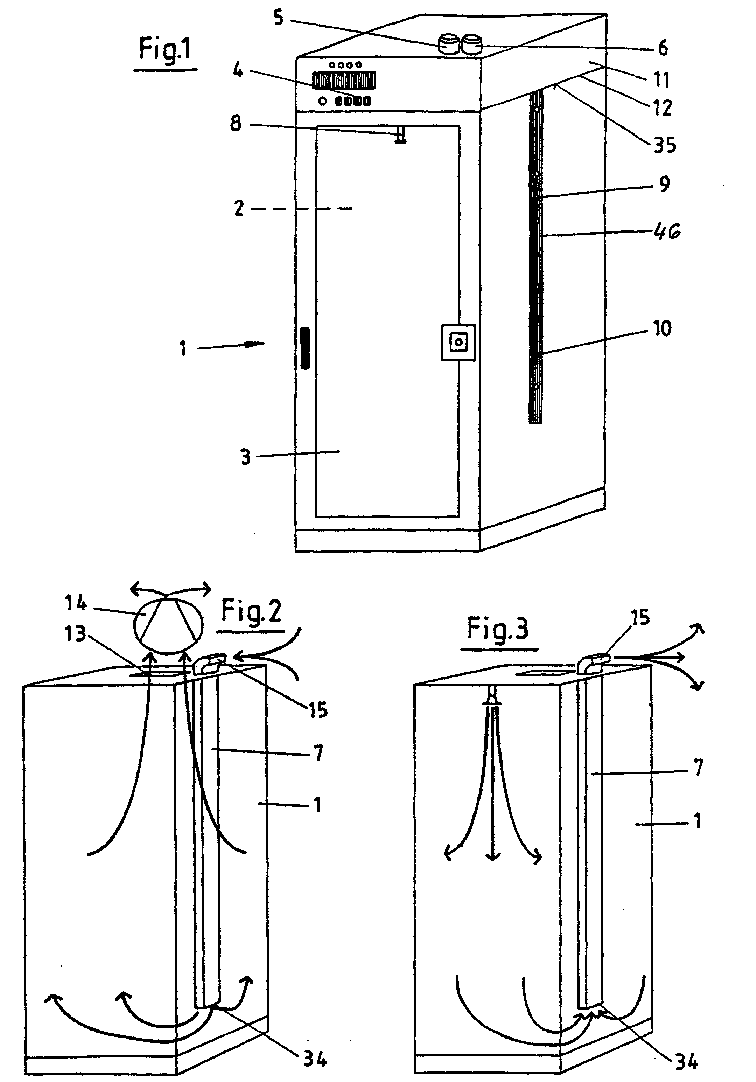

Fig. 1 zeigt einen Schaltschrank, der als Schutzschrank 1 ausgebildet ist. Dies besagt, dass er einen großen Innenraum 2 hat, der gegen die Außenatmosphäre abgesichert ist. Der Innenraum ist über die Schranktür 3 begehbar, wobei im oberen Bereich ein großes Anzeigenfeld 4 vorgesehen ist, über das eine Klartextbedienerführung möglich ist.

Dem oberen Teil des Schutzschrankes 1 sind eine Alarmhupe 6 und eine Alarmlampe 5 zugeordnet. Angedeutet ist in Fig. 1, dass in den Innenraum 2 hineinreichende Versorgungsrohr 7 und eine Hochdruckgasdüse 8, über die ein Edelgas, hier Argon in den Innenraum 2 hineingedrückt werden kann.

Das Ansaugrohr 46 ist übrigens mit mehreren Bohrungen 9, 10 versehen, die über die Länge verteilt dafür sorgen, dass die einströmende Luft wie in Fig. 2 gezeigt auch über die Länge des Versorgungsrohres 7 verteilt in den Innenraum 2 einströmen kann.

Das Anzeigenfeld 4 mit den entsprechenden Klartextbedienerteilen ist einem oben auf dem Schutzschrank 1 aufgesetzten Zusatzschrank 11 zugeordnet, wobei der Zusatzschrank 11 mit dem Oberteil 12 des Schutzschrankes 1 verbunden ist.

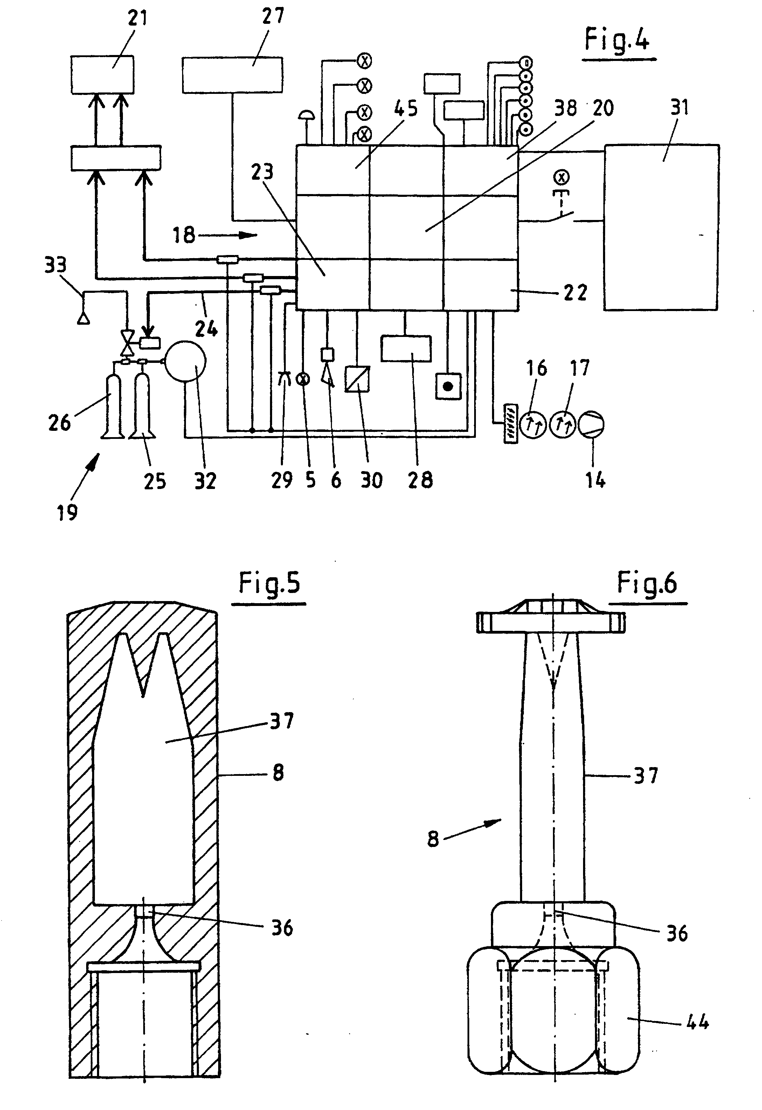

Fig. 2 zeigt den Normalbetrieb eines derartigen Schutzschrankes 1, wobei über den Ventilator 14 Frischluft in den Innenraum 2 hineingezogen wird. Dazu ist das Versorgungsrohr 7 mit einem aus dem Schutzschrank 1 bzw. Zusatzschrank 11 herausragenden Stutzen verbunden, dem eine Ansaug- und Luftaustrittsdüse 15 zugeordnet ist. Im in Fig. 2 dargestellten Beispiel wird über die Ansaugdüse 15 Luft in das Versorgungsrohr 7 und von dort in den Innenraum 2 gesaugt, um dann den Innenraum 2 zu durchströmen und am oberen Ende durch den Ventilator 14 abgesaugt zu werden. Fig. 4 kann dabei entnommen werden, dass im Bereich des Ventilators 14 mehrere Brandfrüherkennungssensoren 16, 17 angeordnet sind. Dabei ist einer der Brandfrüherkennungssensoren 16 so ausgebildet, dass er früher als der zweite Brandfrüherkennungssensor 17 schaltet und zwar zunächst den Server, sodass die entsprechenden Daten gesicehrt werden. Erst nach Ansprechend des zweiten Brandfrüherkennungssensors 17 erfolgt dann die Schaltung der weiteren Steuerung 18 und des Löschteils 19.

Die hier angesprochene Löschung wird dann eingeleitet, wenn die Brandfrüherkennungssensoren 16, 17, die vor dem Ventilator 14 angeordnet sind, entsprechende Steuervorgänge auslösen. Dann wird die in Fig. 2 angedeutete Öffnung 13 geschlossen und gleichzeitig die Verbindung zu den erst in Fig. 4 dargestellten Gasflaschen 25, 26 hergestellt, sodass über die Verbindung 33 Argon über die Hochdruckgasdüse 8 in den Innenraum 2 einströmen kann. Argon wird durch fraktionierte Destillation von verflüssigter Luft gewonnen und unter andernem auch in bedeutenden Mengen als Schutzgas beim elektrischen Schweißen eingesetzt sowie auch bei der Verarbeitung mancher Metalle z. B. Titan. Argon kommt auch in der Luft vor. Es ist für die Umwelt völlig schadlos. Von daher kann es dann, nachdem es den Innenraum 2 des Schutzschrankes 1 durchströmt hat auch problemlos über die Luftaustrittsdüse bzw. besser gesagt Argonaustrittsdüse 15 den Schutzschrank 1 wieder verlassen. Entsprechendes verdeutlicht Fig. 3. Fig. 4 zeigt ein Funktionsschema wobei weiter vorne bereits darauf hingewiesen worden ist, dass hier der Ventilator 14 mit den vorgeordneten Brandfrüherkennungssensoren 16, 17 angedeutet ist. Die nachgeordnete Steuerung 18 dient gleichzeitig als Brandmeldeanlage 20 und ist mit einer Brandmeldezentrale 21 verbunden, sodass bei auftretendem Brand auch die Zentrale kurzfristigst unterrichtet wird. Die entsprechenden Signale werden vom A/D-Wandler 22 entsprechend umgeformt und dem Relaisausgang 23 weitergegeben, von wo zunächst einmal die Schaltung 30 Server down erfolgt und dann erst die Schaltung 29 Server aus. Gleichzeitig erfolgt die Ansprache der Alarmhupe 6 und Alarmlampe 5, sodass eine rundum Information gesichert ist. Auf dem Display 27 werden die entsprechenden Informationen ebenso sichtbar, wie wenn über den power fail 28 das ganze System von Hand eingeschaltet worden wäre.

Über das Netzteil 31 ist sichergestellt, dass auch über lange Zeiten beispielsweise 72 Stunden die Anlage völlig autark arbeitet, wenn ein Stromausfall eingetreten ist.

Am linken Außenrand des Funktionsschemas sind die Gasflaschen 25, 26 erkennbar, die über die Verbindungsleitung 24 mit den entsprechenden Befehlen versorgt werden. Tritt dieser Fall ein, so werden die entsprechenden Ventile geöffnet und das Argon kann aus den Gasflaschen 25, 26 und die Verbindung 33 in Richtung Schaltschrank und Schutzschrank 1 strömen. Die Menge des in den Gasflaschen 25, 26 vorhandenen Löschmittel (Argon) wird anhand der Druck-/Inhaltsrelation mit Hilfe eines kaliibrierten Kolbendruckschalters 32 überwacht. Mit 34 ist die schrankseitige Öffnung des Versorgungsrohres 7 bezeichnet, die in der Nähe des Bodens des Schutzschrankes 1 angeordnet ist. Mit 35 wurde die Deckwand bezeichnet, in die die Hochdruckgasdüse 8 eingesetzt ist, aus der im Brandfalle Argon in den Innenraum 2 einströmt.

Eine solche Hochdruckgasdüse 8 ist in den Figuren 5 und 6 wiedergegeben, wobei hier mit nur angedeutet werden soll, dass die Hochdruckgasdüse 8 eine Doppelfunktion erfüllt, nämlich erstmal mit dem Aufwärmauslass 36 dafür sorgt, dass das Gas nicht zusätzlich abgekühlt wird und mit dem großen Verteilraum 37 dass das Gas sich gleichmäßig über den Innenraum 2 des Schutzschrankes 1 verteilt.

Bei Fig. 4 sind weitere Funktionen angedeutet, so dass Eingangsrelais 38 über das die Befugnis überprüft werden kann, über die die Hupe ausgestellt werden kann oder sonstige Störungen annuliert werden. Weitere Funktionen können damit erfüllt werden. Auf der gegenüberliegenden Seite sind die Ausgänge 45 angedeutet, bezüglich der entsprechenden Angaben Betrieb, Störung, Alarm und Rückmeldung der Brandmeldezentrale 21.

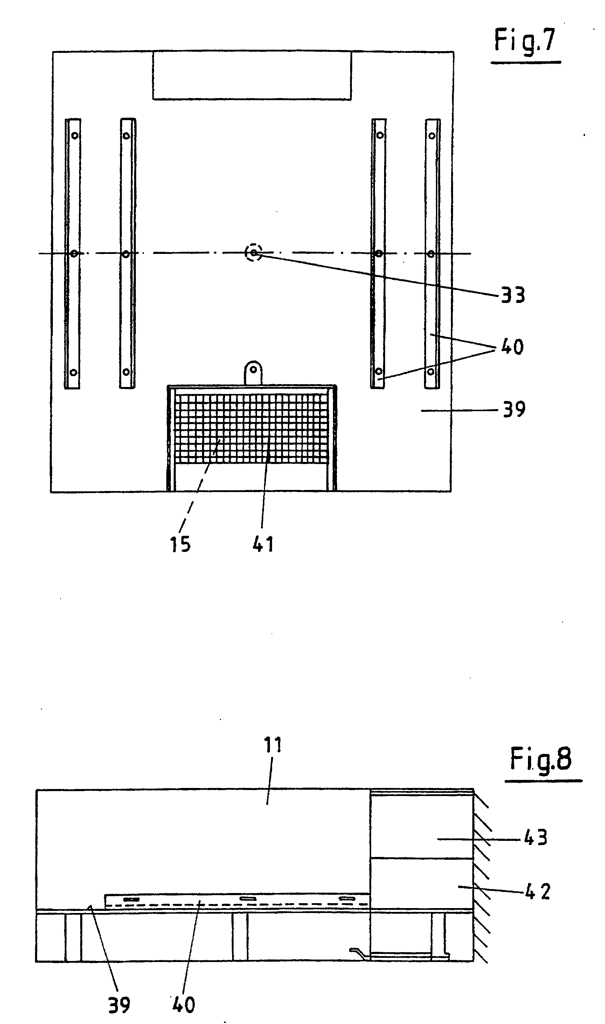

Die Figuren 7 und 8 schließlich zeigen den Zusatzschrank 11 in Draufsicht, wobei deutlich wird, dass hier auf der Oberseite 39 Halterungen 40 für Gasflaschen 25, 26 vorgesehen sein können, um die gesamte Anlage möglichst kompakt auszubilden. Die Ansaug- und Luftaustrittsdüse 15 ist durch eine Gitterabdeckung 41 gesichert, wobei alle Teile durch Verschraubung leicht von der Oberseite 39 lösbar sind.

Fig. 8 schließlich zeigt den Zusatzschrank 11 im Schnitt, wobei wiederum die Halterungen 40 erkennbar sind, darüber hinaus aber auch die seitlich angebrachten Ventilatorkammern 42 und Sensorkammern 43. Mit 44 ist übrigens bei der Hochdruckgasdüse 8 das untere Teil gekennzeichnet, das als Schraubteil ausgebildet ist, um das Einschrauben der Düse zu erleichtern.

Der kompakte Schutzschrank 1 mit Zusatzschrank 11 kann in Varianten mit unterschiedlichem Gasvolumen hergestellt und angeboten werden, wodurch die entsprechende Brandsicherung bei der Planung neuer Schaltschränke problemlos berücksichtigt werden kann. Auch die Nachrüstung bestehender Schaltschränke ist mit geringem Installationsaufwand möglich.

Eine integrierte Prozesssteuerung kann mit Hilfe der Datenschnittstelle Verbindung mit einem externen Computersystem aufnehmen. Alle Alarm-, Status- und Fehlerfunktionen des gesicherten Schaltschrankes sind über diese Datenschnittstelle abrufbar. Weiterhin wird auch das Betriebsprogramm, welches auf dem Prozessrechner innerhalb des Schutzschrankes 1 abläuft über diese Datenschnittstelle geladen. Bei der Wartung, Installation oder Instandsetzung, werden mit Hilfe eines speziell entwickelten Computerprogramms das auf einem externen Computersystem läuft die einzelnen Schritte der Wartungs-, Installations- oder Instandsetzungsarbeiten protokolliert. Das externe Computerprogramm kommuniziert dabei über die Datenschnittstelle mit dem Schutzschrank 1 und verifiziert die vom Wartungspersonal gegebenen Antworten auf die vom Programm gestellten Fragen zum Arbeitsablauf der Wartungs- oder Instandsetzungsarbeiten. Alle auf diesem Wege gewonnenen Daten werden von diesem Computerprogramm in einer Datenbank aufgezeichnet, sodass die vollständige Historie aller am Schutzschrank 1 vorgenommenen Arbeiten nachvollzogen werden kann. Diese Maßnahme dient der Betriebssicherheit des Schutzschrankes 1. Alle durchgeführten Arbeiten werden dann in einem Arbeitsprotokoll zusammengefasst, das mit Hilfe des Computerprogramms nach Abschluss der Arbeiten automatisch ausgedruckt wird.

Mehrere der oben beschriebenen Anlagen können mit einem speziell entwickelten Kommunikationsbus miteinander verbunden werden. Die mit diesen Anlagen geschützten Schutzschränke 1 werden dann zu einem Schutzbereich miteinander verschaltet. Eine der Anlagen, der Master, ist dann mit der Steuerung- und Informationsverarbeitungsanlage ausgestattet. Durch den Kommunikationsbus werden alle Status-, Alarm und Fehlerinformationen der gekoppelten Anlagen zu dem Zentralgerätgemeldet. Die Anzahl der gekoppelten Anlagen ist nur von der Möglichkeit beschränkt unterschiedliche Informationen über den Kommunikationsbus zu übertragen. Der Kommunikationsbus kann auf unterschiedliche Weise realisiert werden. Es ist sowohl eine kabelgebundene als auch eine kabellose Informationsübertragung vorgesehen.

Die oben beschriebenen Bestandteile der Anlage können auch so ausgeführt sein, dass einzelne Komponenten mehrfach vorhanden sein können. Diese Komponenten werden dann mit Hilfe von Kabel- oder anderweitigen Verbindungen mit dem Grundschutzschrank 1 verbunden und ermöglichen so eine einfache Erweiterung der Funktionalität der Anlage. Zum Beispiel ist es dann möglich, die Kapazität des Löschmittelvorrats in den (Hochdruck) Gasflaschen 25, 26 zu erweitern oder aber die Menge der dem Schutzschrank 1 zugeführten Kühlluft zu vergrößern.

Zusätzlich zur Überwachung auf Brandrückstände in der Abluft des Schutzschrankes 1 kann ebenfalls die Überwachung weiterer physikalischer Daten vorgenommen werden. Gleichzeitig mit der Branddetektion werden auch Werte zur Temperatur, Luftfeuchtigkeit und Leistungsaufnahme des Schutzschrankes 1 mit entsprechenden Sensoren ermittelt und können dann über die oben beschriebene Datenschnittstelle zur Weiterverarbeitung übermittelt oder von der Prozesssteuerung der Gesamtanlage verarbeitet werden. Mit Hilfe dieser zusätzlich gewonnenen Daten ist es dann z. B. möglich, die Luftzufuhr des überwachten Schutzschrankes 1 zu regeln oder aber bei Erreichen voreingestellter Werte eine Alarmierung des Bedienungspersonals auszulösen.

Alle genannten Merkmale, auch die den Zeichnungen allein zu entnehmenden, werden allein und in Kombination als erfindungswesentlich angesehen.

## Patentansprüche

1. Schaltschrank für Server u. ä. Einbauten insbesondere Teile empfindlicher Computereinrichtungen, dessen Innenraum (2) mit Löschgas enthaltenden Gasflaschen (25, 26) verbunden ist und kontinuierlich über einen Ventilator (14) mit Frischluft versorgt ist, wobei in den Abgasstrom ausserhalb des Innenraums (2) Brandfrüherkennungssensoren (16,17) geschaltet sind und wobei die Verbindung (33) im Brandfall aktiviert ist
**dadurch gekennzeichnet,**
**dass** der Innenraum (2) in einem gegen die Atmosphäre abgeschlossenen Schutzschrank (1) ausgebildet und dass die im Brandfall über die Brandfrüherkennungssensoren (16, 17) aktivierten Gasflaschen (25, 26) mit dem Edelgas Argon gefüllt sind und dass der Innenraum (2) über ein Versorgungsrohr (7) mit der Atmosphäre verbunden ist, das am ausserhalb des Schutzschrankes (1) befindlichen Ende eine kombinierte Ansaug- und Luftaustrittsdüse (15) mit Gitterabdeckung (41) aufweist und dass die Branderkennungssensoren (16,17) und die gesamte Steuerung (18) einem dem Schutzschrank (1) zugeordneten Zusatzschrank (11) zugeordnet sind.

2. Schaltschrank nach Anspruch 1,
**dadurch gekennzeichnet,**
**dass** der Zusatzschrank (11) dem Oberteil (12) des Schutzschrankes (1) angepasst ist, auch den Ventilator (14) aufnimmt und mit dem Oberteil (12) verbunden ist.

3. Schaltschrank nach einem der vorhergehenden Ansprüche,
**dadurch gekennzeichnet,**
**dass** der Ventilator (14) im Normalbetrieb auf Saugung geschaltet ist und im Brandfall von der Steuerung (18) gestoppt ist.

4. Schaltschrank nach einem der vorhergehenden Ansprüche,
**dadurch gekennzeichnet,**
**dass** der Zusatzschrank (11) mit dem Innenraum (2) über ein Ansaugrohr (46) verbunden ist, das über seine Länge gesehen mehrere Bohrungen (9, 10) aufweist.

5. Schaltschrank nach einem der vorhergehenden Ansprüche,
**dadurch gekennzeichnet,**
**dass** die Verbindung (33) zwischen Gasflaschen (25, 26) und Schutzschrank (1) als Rohrleitung ausgebildet ist, die in der Deckwand (35) des Schutzschrankes (1) in Form einer Hochdruckgasdüse (8) endet.

6. Schaltschrank nach Anspruch 7,
**dadurch gekennzeichnet,**
**dass** die Hochdruckgasdüse (8) einen Aufwärmauslass (36) und einen Entspannungsund Verteilraum (37) aufweisend ausgebildet ist.

7. Schaltschrank nach einem der vorhergehenden Ansprüche,
**dadurch gekennzeichnet,**
**dass** der Zusatzschrank (11) auf der Oberseite (39) Halterungen (40) für Gasflaschen (25, 26) aufweist.

8. Schaltschrank nach einem der vorhergehenden Ansprüche,
**dadurch gekennzeichnet,**
**dass** mindestens zwei Brandfrüherkennungssensoren (16, 17) vorgesehen sind, die unterschiedliche Schaltzeiten haben, wobei der mit der kürzeren Schaltzeit der Steuerung (18) und dem Server bzw. Datensicherungsgerät und der mit der längeren Schaltzeit der Steuerung (18) und dem Löschteil (19) zugeschaltet ist.

9. Schaltschrank nach einem der vorhergehenden Ansprüche,
**dadurch gekennzeichnet,**
**dass** die Steuerung (18) zugleich als Brandmeldeanlage (20) ausgerüstet und mit dem Löschteil (19) und einer Brandmeldezentrale (21) verbunden ist.

10. Schaltschrank nach einem der vorhergehenden Ansprüche,
**dadurch gekennzeichnet,**
**dass** der Steuerung (18) bzw. dem Zusatzschrank (11) ein von Hand zu bedienender Power fail (28) zugeordnet ist.

## Claims

1. Switchgear cabinet for server *inter alia* built-in components, in particular parts of sensitive computer equipment, the interior (2) of which is connected to gas cylinders (25, 26) containing quenching gas and is continuously supplied with fresh air via a ventilator (14), fire early recognition sensors (16, 17) being connected into the waste-gas flow outside the interior (2), **characterised in that** the interior (2) is formed in a protective cabinet (1) closed against the atmosphere and **in that**, in the event of a fire, gas cylinders (25, 26) activated via the fire early recognition sensors (16, 17) are filled with the inert gas argon and **in that** the interior (2) is connected to the atmosphere via a supply pipe (7) which has a combined inlet and air outlet nozzle (15) with a grid cover (41) at the end located outside the protective cabinet (1) and **in that** the fire recognition sensors (16, 17) and the entire control (18) are associated with an additional cabinet (11) associated with the protective cabinet (1).

2. Switchgear cabinet according to claim 1, **characterised in that** the additional cabinet (11) is adapted to the upper part (12) of the protective cabinet (1), also receives the ventilator (14) and is connected to the upper part (12).

3. Switchgear cabinet according to any one of the preceding claims, **characterised in that** the ventilator (14) is switched to suction in normal operation and in the event of fire is stopped by the control (18).

4. Switchgear cabinet according to any one of the preceding claims, **characterised in that** the additional cabinet (11) is connected to the interior (2) via an inlet pipe (46) which has a plurality of holes (9, 10) seen over its length.

5. Switchgear cabinet according to any one of the preceding claims, **characterised in that** the connection (33) is designed as tubing between gas cylinders (25, 26) and protective cabinet (1), which tubing ends in the covering wall (35) of the protective cabinet (1) in the form of a high pressure gas nozzle (8).

6. Switchgear cabinet according to claim 7, **characterised in that** the high pressure gas nozzle (8) is designed so as to have a heating outlet (36) and a pressure-release and distribution space (37).

7. Switchgear cabinet according to any one of the preceding claims, **characterised in that** the additional cabinet (11) has holding devices (40) for gas cylinders (25, 26) on the upper side (39).

8. Switchgear cabinet according to any one of the preceding claims, **characterised in that** at least two fire early recognition sensors (16, 17) are provided which have different switching times, wherein the one with the shorter switching time is connected to the control (18) and the server or data backup device and the one with the longer switching time is connected to the control (18) and the quenching part (19).

9. Switchgear cabinet according to any one of the preceding claims, **characterised in that** the control (18) is simultaneously equipped as a fire signalling system (20) and is connected to the quenching part (19) and a fire signalling control centre (21).

## Revendications

1. Armoire de distribution pour des serveurs ou des inserts similaires, notamment des pièces de dispositifs d'ordinateurs sensibles, dont l'espace intérieur (2) est relié à des bouteilles de gaz (25, 26) contenant un gaz d'extinction et est alimenté en permanence en air frais par l'intermédiaire d'un ventilateur (14), dans laquelle des capteurs (16, 17) d'identification précoce d'incendie sont montés dans le courant de gaz d'évacuation à l'extérieur de l'espace intérieur (2), et la liaison (33) est activée dans le cas d'un incendie, **caractérisé en ce que** l'espace intérieur (2) est formé dans une armoire de protection (1) fermée vis-à-vis de l'atmosphère et que les bouteilles de gaz (25, 26) activées dans le cas d'un incendie par l'intermédiaire des capteurs (16, 17) d'identification précoce d'un incendie, sont remplies par le gaz rare argon et que l'espace intérieur (2) est relié à l'atmosphère par l'intermédiaire d'un tube d'alimentation (7), qui possède, au niveau de l'extrémité située à l'extérieur de l'armoire de protection (1), une buse combinée d'aspiration et de sortie d'air (15) pourvue d'un élément de recouvrement en forme de grille (41), et que les capteurs (16, 17) d'identification d'incendie et l'ensemble de l'unité de commande (18) sont associés à une armoire supplémentaire (11) associée à l'armoire de protection (1).

2. Armoire de distribution selon la revendication 1, **caractérisée en ce que** l'armoire supplémentaire (11) est adaptée à la partie supérieure (12) de l'armoire de protection (1), loge également le ventilateur (14) et est reliée à la partie supérieure (12).

3. Armoire de distribution selon l'une des revendications précédentes, **caractérisée en ce que** pendant le fonctionnement normal, le ventilateur (14) est branché de manière à être aspirant et, dans le cas d'un incendie, est bloqué par l'unité de commande (18).

4. Armoire de distribution selon l'une des revendications précédentes, **caractérisée en ce que** l'armoire supplémentaire (11) est reliée à l'espace intérieur (2) par l'intermédiaire d'un tube d'aspiration (46), qui possède plusieurs perçages (9, 10), sur sa longueur.

5. Armoire de distribution selon l'une des revendications précédentes, **caractérisée en ce que** la liaison (33) entre les bouteilles de gaz (25, 26) et l'armoire de protection (1) est agencée sous la forme d'une conduite tubulaire, qui se termine dans la paroi de plafond (35) de l'armoire de protection (1), sous la forme d'une buse de gaz à haute pression (8).

6. Armoire de distribution selon la revendication 7, **caractérisée en ce que** la buse à gaz à haute pression (8) est agencée de manière à comporter une sortie de chauffage (36) et une chambre de détente et de répartition (37).

7. Armoire de distribution selon l'une des revendications précédentes, **caractérisée en ce que** l'armoire supplémentaire (11) possède, sur sa face supérieure (39), des dispositifs de retenue (40) pour les bouteilles de gaz (25, 26).

8. Armoire de distribution selon l'une des revendications précédentes, **caractérisée en ce qu'**il est prévu au moins deux capteurs (16, 17) d'identification précoce d'incendie, qui possèdent des durées de commutation différentes, le capteur possédant la durée de commutation la plus courte étant associé à l'unité de commande (18) et au serveur ou à l'appareil de sauvegarde de données, et le capteur possédant la durée de commutation la plus longue étant associé à l'unité de commande (18) et à la partie d'extinction (19).

9. Armoire de distribution selon l'une des revendications précédentes, **caractérisée en ce que** l'unité de commande (18) est équipée simultanément en tant qu'installation de signalisation d'incendie (20) et est reliée à la partie d'extinction (19) et à une centrale de signalisation d'incendie (21).

10. Armoire de distribution selon l'une des revendications précédentes, **caractérisée en ce qu'**un dispositif Power fail (28) devant être actionné manuellement est associé à l'unité de commande (18) ou à l'armoire supplémentaire (11).
